# EUROPÄISCHE PATENTSCHRIFT

(11) **EP 0 980 131 B1**
(45) Veröffentlichungstag und Bekanntmachung des Hinweises auf die Patenterteilung: **29.06.2005**
(21) Anmeldenummer: 99115680.3
(22) Anmeldetag: 09.08.1999
(51) Int. Cl.: H02J 9/06, H02J 7/00, G01R 31/36

(54) **Verfahren und Überwachungsvorrichtung zur Überwachung wenigstens eines von zur Notversorgung von elektrischen und/oder elektronischen Verbrauchern zuschaltbaren Batteriesatzes**
Method and apparatus for monitoring of at least one switchable battery-set for the emergency supply of electrical and/or electronic consumers
Procédé et dispositif de surveillance d'au moins un ensemble de batteries pour l'alimentation de secours de consommateurs électriques et/ou électroniques

(30) Priorität: 10.08.1998 DE 19836141
(43) Veröffentlichungstag der Anmeldung: 16.02.2000
(73) Patentinhaber: CEAG Notlichtsysteme GmbH, 59494 Soest (DE)
(72) Erfinder: Prasuhn, Jürgen, 59494 Soest (DE)
(74) Vertreter: Grünecker, Kinkeldey, Stockmair & Schwanhäusser Anwaltssozietät

(56) Entgegenhaltungen:
- EP-A- 0 080 164
- EP-A- 0 798 839
- WO-A-98/07226
- DE-A- 19 508 345
- US-A- 5 625 272

## Beschreibung

Die Erfindung betrifft ein Verfahren und eine Überwachungsvorrichtung zur Überwachung wenigstens eines zur Notversorgung von elektrischen und/oder elektronischen Verbrauchern, insbesondere von Zentralbatterie-Notlichtsystemen, zuschaltbaren Battiersatzes mit den Merkmalen der Oberbegriffe der Patentansprüche 1 beziehungsweise 12.

Aus der Praxis sind ein solches Verfahren bzw. eine solche Überwachungsvorrichtung bekannt. Bei den vorbekannten Verfahren misst eine Steuereinrichtung wenigstens eine Gesamtspannung zwischen Plus- und Minus-Anschluß einer Anzahl von in Reihe geschalteten Batterien des Batteriesatzes und lädt die Batterie mittels einer Ladeeinrichtung gegebenenfalls wieder auf.

Eine entsprechende Steuer- und/oder Ladeeinrichtung ist vorrichtungsmäßig mit den Plus- und Minus-Anschlüssen des Batteriesatzes zur Ermittlung einer Gesamtbatteriespannung verschaltet. Ein solcher Batteriesatz oder mehrere solcher Sätze dienen als Zentralbatteriesystem für die Notversorgung von beispielsweise Notlichtversorgungssystemen. In der Regel findet eine jährliche Überprüfung des Batteriesatzes bzw. des Zentralbatteriesystemes statt, die aus einem technischen Funktionstest und einem Betriebsdauertest besteht.

Ein solcher Batteriesatz besteht beispielsweise aus 108 Einzelbatterien von jeweils 2 V, so dass der Batteriesatz insgesamt 216 V als Gesamtspannung abgeben kann. Falls einzelne oder mehrere dieser Einzelbatterien ausfallen, sinkt die Gesamtspannung und die Spannungsversorgung durch den Batteriesatz ist möglicherweise unzureichend für eine ausreichende Beleuchtung durch das Notlichtversorgungssystem.

US 5,625,272 zeigt ein Verfahren zur Batterieentladung beziehungsweise -beladung. Die Batterie ist aus einer Anzahl von Zellen zusammengesetzt, die in Serie verschaltet sind. Die Vielzahl von Zellen sind in eine Anzahl von Blöcken unterteilt und die Differenz zwischen einem Maximalspannungswert und einem Minimalspannungswert ausgewählt aus der Gruppe der Blöcke wird berechnet. Auf der Grundlage des erhaltenen Differenzwertes zwischen Maximal- und Minimalspannung wird die Ladung beziehungsweise Entladung der Batterien gesteuert.

WO98/07226 A zeigt ein Verfahren und eine Vorrichtung zur Überwachung oder Steuerung des Ladens einer modularen Batterie. Eine Vielzahl von Batterien sind in Serie verschaltet. Jeder Batterie ist eine modulare Steuereinheit zugeordnet. Diese werden zur Erfassung von Temperatur und Spannung einer jeden einzelnen Batterie verwendet.

EP 0 798 839 A betrifft ein Überwachungsgerät für eine Batterie aus einer Vielzahl von Einzelbatterien. Diese sind in Serie miteinander verschaltet. Ein Batterieüberwachungsmodul ist parallel zu jeder Einzelbatterie verschaltet und mit einem Interfacemodul verbunden. Die Batterieüberwachungsmodule dienen zur Überwachung von Spannung und Temperatur der jeweils zugeordneten Einzelbatterie.

Der vorliegenden Erfindung liegt die Aufgabe zugrunde, frühzeitig den Ausfall einzelner oder mehrerer Einzelbatterien zu detektieren und dadurch eine höhere Systemverfügbarkeit zu gewährleisten.

Diese Aufgabe wird durch die kennzeichnenden Merkmale der Ansprüche 1 beziehungsweise 12 gelöst.

Verfahrensmäßig werden neben der Gesamtspannung zumindest über eine weitere Anzapfung des Batteriesatzes Spannungen zwischen zumindest Anzapfung und jeweils Plus- und Minus-Anschluß gemessen, ein Differenzwert dieser gemessenen Spannungen wird ermittelt und ein Differenzwertsignal an die Steuer- und/oder Ladeeinrichtung über eine Fühlerleitung übertragen, wobei die Übertragung des Differenzwertsignals bei einem Differenzwert der gemessenen Spannungen größer als einem vorgegebenen Grenzdifferenzwert erfolgt.

Vorrichtungsgemäß ist eine Überwachungseinrichtung mit zumindest einer weiteren Spannungsanzapfung des Batteriesatzes verbunden und weist eine Vergleicherschaltung zur Ermittlung von Spannungswerten zwischen Spannungsanzapfung und Plussowie Minus-Anschluß sowie zur Auswertung einer Spannungsdifferenz zwischen diesen Spannungswerten auf.

Durch diese zusätzlich ermittelten Spannungen und ihre Differenz ist feststellar, ob eine einzelne oder mehrere der Batterien des Batteriesatzes zwischen Spannungsanzapfung und Plus- oder Minus-Anschluß ausgefallen sind. Die normalerweise zwischen der Spannungsanzapfung und dem Plus- oder Minus-Anschluß anliegenden Spannungen ergeben sich durch die Einzelspannungen der zwischen diesen Anschlüssen angeordneten Anzahl von Einzelbatterien. Stimmt ein gemessener Spannungswert nicht mit dem erwarteten Spannungswert überein, ist ein Ausfall oder Kurzschluß einer oder mehrerer Einzelbatterien zwischen Spannungsanzapfung und Plus- oder Minus-Anschluß erfaßt.

Vorzugsweise kann die Spannungsanzapfung des Batteriesatzes mittig oder symmetrisch als Mittenzapfung erfolgen. Auf diese Weise müssten bei einer geraden Anzahl von Batterien die beiden zwischen Mittenanzapfung und Plus- bzw. Minus-Anschluß gemessenen Spannungswerte gleich sein. Bei einer Unsymmetrie der Spannungswerte kann auf einen Ausfall oder Kurzschluß einer entsprechenden Anzahl von Einzelbatterien geschlossen werden.

Um erst bei Ausfall einer sicherheitsbeeinflussenden Anzahl von Einzelbatterien beispielsweise eine Meldung über eine nicht mehr ausreichende Funktion des Batteriesatzes zu erhalten oder um gewisse Spannungsschwankungen beim Laden, bzw. Entladen des Batteriesatzes zu berücksichtigen, kann eine Übertragung des Differenzwertsignals durch die Überwachungsvorrichtung zur Steuer- und/oder Ladeeinrichtung beispielsweise auch erst bei einem Differenzwert der gemessenen Spannungen größer als ein vorgegebener Grenzdifferenzwert erfolgen.

Um gleichzeitig ein Laden des Batteriesatzes durch die Ladeeinrichtung neben der Überwachung durch die Überwachungsvorrichtung zu gewährleisten, können diese parallel an dem Plus- und Minus-Anschluß des Batteriesatzes angeschlossen sein. Die Überwachungsvorrichtung ist dabei weiterhin mit der Mittenanzapfung verbunden. Es sei an dieser Stelle darauf hingewiesen, daß statt einer Symmetrieüberwachung mit Mittenanzapfung beispielsweise auch eine Drittel-, Viertel- usw. Überwachung erfolgen kann, d.h. die Überwachungsvorrichtung ist mit zwei, drei, vier oder mehr Anzapfungen des Batteriesatzes verbunden. Bei einer solchen Anordnung werden jeweils die Spannungen zwischen einer Anzapfung und zu dieser benachbarten Anzapfungen bzw. Plus- und Minus-Anschlüssen ermittelt und beispielsweise mit den übrigen Spannungswerten verglichen, wobei bei einer Drittelüberwachung drei Spannungswerte von jeweils einem Drittel der Gesamtspannung, bei einer Viertelüberwachung vier Spannungswerte von jeweils einem Viertel der Gesamtspannung usw. ermittelt und verglichen werden.

Die Einzelbatterien sind zur Bildung des Batteriesatzes miteinander in der Regel in einem Batterieschrank untergebracht, wobei dieser Batterieschrank auch mehrere Batteriesätze enthalten kann. Bei einem einfachen Ausführungsbeispiel kann zumindest die Überwachungsvorrichtung ebenfalls in dem Batterieschrank angeordnet sein. Auf diese Weise ist eine dezentrale Überwachung eines jeden Batteriesatzes möglich.

Um die Batteriesätze temperaturgeführt laden zu können, kann jedem der Batteriesätze ein Temperatursensor zur Messung der Umgebungstemperatur zugeordnet sein, welcher über eine entsprechende Fühlerleitung mit der Lade- und/oder Steuereinrichtung zur Übermittlung eines entsprechenden Temperatursignals verbunden ist. Solche Temperatursensoren sind in der Regel sinnvoll, um die Batterien mit vom Batteriehersteller vorgegebenen, temperaturabhängigen Daten entsprechend zu laden. Die Fühlerleitung ist beispielsweise eine 2-polige Leitung, die mit der Steuer- und/oder Ladeeinrichtung verbunden ist. Dabei kann der Temperatursensor benachbart zum Batteriesatz innerhalb des Batterieschrankes angeordnet sein.

Zur Vereinfachung des Gesamtsystemes ist es weiterhin als vorteilhaft zu betrachten, wenn die Daten des Temperatursensors beispielsweise nur zur Ladeeinrichtung übermittelt werden, wobei diese über eine eigene Steuereinrichtung in Form beispielsweise eines Mikroprozessors verfügen kann, um die Ladung des Batteriesatzes temperaturgeführt durchführen zu können.

Das Verfahren bzw. die entsprechende Vorrichtung zur Überwachung werden weiterhin vereinfacht, wenn die Ladeeinrichtung mit ihrer Steuereinrichtung auch das Differenzwertsignal direkt empfängt. Um den Verschaltungsaufwand in diesem Zusammenhang zu minimieren, kann der Empfang des Differenzwertsignals über die Fühlerleitungen erfolgen.

Weiterhin kann die Überwachungseinrichtung direkt von dem Batteriesatz versorgt werden, indem sie mit diesem zur Spannungsversorgung verbunden ist. Dadurch entfällt die Notwendigkeit eine eigene Batterie innerhalb des Batterieschrankes oder eine eigene Spannungsversorgung von außen für die Überwachungseinrichtung anzuordnen.

Um das Differenzwertsignal in einfacher Weise zu bestimmen, kann die Vergleichsschaltung eine Auswerteeinheit aufweisen und mit dem Plus-und Minus-Anschluß und der zumindest einen weiteren Batterieanzapfung zur Bestimmung der dem Differenzwertsignal entsprechenden Spannungsdifferenz verbunden sein.

Die Übermittlung des Differenzwertsignals über die Fühlerleitung kann beispielsweise dadurch erfolgen, daß das Differenzwertsignal durch getaktetes Belasten oder Hochohmigschalten der Fühlerleitung übertragen wird. Dies kann bei einer Symmetrieüberwachung sowohl bei einem Differenzwertsignal gleich Null als auch bei einem Differenzwertsignal größer als einem vorbestimmten Wert erfolgen. Eine Differenzwertsignal gleich Null ergibt sich beispielsweise, wenn die bei einer Mittenanzapfung zwischen dieser und dem Plus- und Minus-Anschluß ermittelten Spannungswerte gleich sind. Dies entspricht einem Batteriesatz, bei dem keine Einzelbatterien ausgefallen sind.

Ein Differenzwertsignal größer als ein vorbestimmter Wert kann sich bei einer Mittenanzapfung ergeben, wenn eine oder mehrere Einzelbatterien einen Kurzschluß aufweisen. Das getaktete Belasten oder Hochohmigschalten kann in diesem Zusammenhang erfolgen, wenn das Differenzwertsignal Null ist oder auch größer als der vorbestimmte Wert ist. Die Taktung erfolgt dabei so langsam, daß weiterhin eine Temperaturüberwachung und temperaturgeführte Ladung aufgrund der relativ trägen Temperaturmessung möglich ist.

Um eine entsprechende Taktung generieren zu können, kann die Vergleichsschaltung mit einem Taktgeber zur Ausgabe von Impulsen in Abhängigkeit zum Differenzwertsignal verschaltet sein. Beispielsweise können mehr oder weniger Impulse bei einem mehr oder weniger hohen Differenzwertsignal ausgegeben werden.

Bei einem einfachen Ausführungsbeispiel kann der Taktgeber ein insbesondere in der Taktfrequenz einstellbarer Oszillator sein.

Zur Übermittlung der Impulse vom Taktgeber, kann dieser mit der Fühlerleitung verbunden sein. Ebenso kann der erzeugte Takt dem Meßsignal des Temperatursensors aufmoduliert sein.

Wenn zumindest zeitweilig auf eine Temperaturüberwachung des Batteriesatzes verzichtet wird, kann das Differenzwertsignal auch durch getaktetes Kurzschließen und Öffnen der Fühlerleitung übertragen werden. Dies kann einerseits bei einem Differenzwertsignal von Null als auch, wie bereits oben ausgeführt, bei einem Differenzwertsignal größer als ein vorgegebener Wert erfolgen.

Ein weiteres Signal kann an die Lade- und/oder Steuereinrichtung dann übermittelt werden, wenn beispielsweise eine fehlende Spannungsanzapfung, insbesondere Mittenanzapfung, detektiert wird.

Dies kann beispielsweise dadurch erfolgen, daß die Taktung der Fühlerleitung zur Informationsübermittlung mit unterschiedlichen, einstellbaren Taktfrequenzen für die Übertragung der Differenzwertsignale oder der Information über eine fehlende Spannungsanzapfung erfolgt.

Um beispielsweise erst bei Ausfall mehrerer Einzelbatterien, d.h. ab einer bestimmten Größe für das Differenzwertsignal eine Information nach außen abzugeben, kann der entsprechende Grenzdifferenzwert durch die Vergleicherschaltung einstellbar sein. Die Einstellung kann ebenfalls dazu benutzt werden, Abweichungen von einem Differenzwertsignal gleich Null zuzulassen, um gewissen Schwankungen bei der Symmetrieüberwachung zuzulassen.

Um in einfacher Weise ein getaktetes Kurzschließen und Öffnen der Fühlerleitung zu ermöglichen, kann zwischen Taktgeber und Fühlerleitung eine Schalt- und/oder Belastungseinheit zum Kurzschließen oder Öffnen bzw. zur Belastung oder zum Hochohmigschalten der Fühlerleitung verschaltet sein.

Im folgenden wird ein vorteilhaftes Ausführungsbeispiel der Erfindung anhand der in der Zeichnung beigefügten Figur näher erläutert und beschrieben.

Es zeigt:

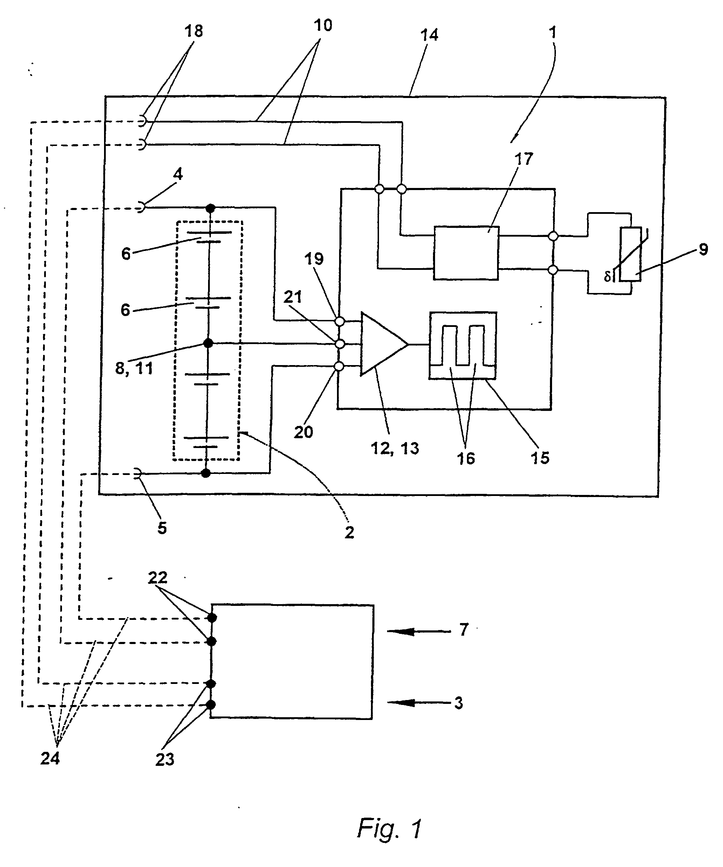

- Fig. 1: eine Prinzipdarstellung einer Schaltung zur Durchführung des erfindungsgemäßen Verfahrens bzw. als erfindungsgemäße Überwachungsvorrichtung.

In Fig. 1 ist ein Batterieschrank 14 dargestellt, der über Leitungen 24 mit zumindest einer Ladeeinrichtung 7 und einer Steuereinrichtung 3 verbunden ist. In analoger Weise können auch mehr als der eine dargestellte Batterieschrank mit diesen Einrichtungen verbunden sein. Solche Batterieschränke enthalten eine Anzahl von in Reihe geschalteten Einzelbatterien 6, die zusammen einen Batteriesatz 2 bilden.

Die Batteriesätze dienen sowohl bei vorhandenem Netz als auch bei Netzausfall dazu, insbesondere Notbeleuchtungssysteme betriebsbereit zu halten. Plus- und Minus-Anschlüsse 4, 5 des Batteriesatzes sind über nicht dargestellte Leitungen mit dem Notlichtversorgungssystem und gleichzeitig mit einer Ladeeinrichtung 7 verbunden. Um die Einzelbatterien entsprechend zu vom Batteriehersteller vorgegebenen Daten temperaturgeführt laden zu können, ist in dem Batterieschrank 14 ein Temperatursensor 9 angeordnet. Dieser ist über eine 2-polige Fühlerleitung 10 mit einer separaten oder einer in der Ladeeinrichtung integrierten Steuereinrichtung 3 verbunden. Die separate Steuereinrichtung kann weiterhin zum Bereitschalten des Batteriesatzes zur Notversorgung eingesetzt werden.

Die Verbindung des Batterieschranks 14 mit Lade- und/oder Steuereinrichtung erfolgt über entsprechende Leitungen 24, die zwischen Anschlüssen 18 der Fühlerleitung 10 und Eingängen 23 bzw. zwischen Plus- und Minus-Anschlüssen 4, 5 des Batteriesatzes 2 und Ausgängen 22 verlaufen.

Ein solcher Batteriesatz 2 besteht in der Regel aus 108 Einzelbatterien mit einer Einzelspannung von 2 V. Dadurch erhält man insgesamt eine Batterie mit einer Gesamtspannung von 216 V. Der Batteriesatz 2 ist bei dem dargestellten Ausführungsbeispiel mit einer als Mittenanzapfung 11 ausgebildeten Anzapfung 8 ausgebildet. Über diese kann eine Mittenspannung nach 54 Einzelbatterien abgefragt werden, wobei eine entsprechende Spannungsmessung sowohl bezüglich des Plus-Anschlusses 4 als auch des Minus-Anschlusses 5 erfolgt.

An dieser Stelle sei angemerkt, daß beispielsweise auch zwei, drei, vier usw. Anzapfungen vorgesehen sein können, die Spannungen von einem Drittel, Viertel, Fünftel usw. der den Batteriesatz bildenden Einzelbatterien messen. Die folgenden Ausführungen gelten analog für solche Batteriesätze mit mehreren Anzapfungen.

Die Mittenanzapfung 8 sowie die Plus- und Minus-Anschlüsse 4, 5 sind mit entsprechenden Eingängen 21, 19 und 20 einer Überwachungsvorrichtung 1 verbunden, die ebenfalls in dem Batterieschrank 14 angeordnet ist. Die Eingänge 19, 20, 21 sind mit einer Vergleicherschaltung 12 mit Auswerteeinheit 13 verbunden. Diese sind Teil der Überwachungsvorrichtung 1. Die Überwachungsvorrichtung 1 ist mit dem Plus- und Minus-Anschluß 4, 5 parallel zur Ladeeinrichtung 7 verschaltet.

In der Vergleicherschaltung 12 werden die Spannungen zwischen Mittenanzapfung 11 und Plus-Anschluß 4 bzw. Minus-Anschluß 5 ermittelt und aus diesen Werten eine Spannungsdifferenz ermittelt. Ist keine der Einzelbatterien 6 bzw. Zellen 6 ausgefallen, sind die beiden ermittelten Spannungswerte gleich und ein aus diesen berechneter Differenzwert ist gleich Null. Mittels dieses Differenzwertes wird der Batteriesatz 2 überwacht, wozu dieser Differenzwert an die Lade- und/oder Steuereinrichtung 7, 3 übermittelt wird. Außerdem kann durch die Auswerteeinheit 13 der Vergleicherschaltung 12 beispielsweise erst dann ein Differenzwertsignal ausgegeben werden, wenn der Spannungsdifferenzwert größer als ein vorbestimmter Wert ist. Dieser vorbestimmte Grenzwert entspricht beispielsweise dem Ausfall einer oder mehrerer Einzelbatterien.

Die Vergleicherschaltung 12 bzw. Auswerteeinheit 13 ist mit einem Oszillator 15 als Taktgeber verbunden. Dieser kann Impulse 16 einstellbarer Frequenz ausgeben. Der Oszillator 15 ist mit einer Schalt- und/oder Belastungseinheit 17 verbunden. Oszillator 15 und Einheit 17 sind Teile der Überwachungsvorrichtung 1, wobei die Schalt- und/oder Belastungseinheit 17 zwischen Temperatursensor 9 und Anschlüssen 18 in der Fühlerleitung 19 verschaltet ist. Die Überwachungsvorrichtung 1 ist über nicht dargestellte Leitungen mit dem Batteriesatz 2 zur eigenen Spannungsversorgung verbunden.

Im folgenden wird kurz die Funktionsweise der dargestellten erfindungsgemäßen Überwachungsvorrichtung anhand der Figur erläutert.

Durch die zwischen Temperatursensor 9 und externer Lade- und Steuereinrichtung 7, 3 verschaltete Überwachungsvorrichtung 1 werden bei dem dargestellten Ausführungsbeispiel zwei Spannungswerte ermittelt. Diese Spannungswerte werden zwischen einer Mittenanzapfung 8 und Plus-Anschluß 4 des Batteriesatzes 4 einerseits und Minus-Anschluß 5 des Batteriesatzes 2 andererseits abgegriffen. Durch die Vergleicherschaltung 12 der Überwachungsvorrichtung 1 wird ein Differenzwert aus den beiden abgegriffenen Spannungswerten ermittelt. Dieser Differenzwert wird als Differenzwertsignal an die Lade- und/oder Steuereinrichtungen 7, 3 nach außen übermittelt. Die Übermittlung erfolgt über die Fühlerleitung 10 des Temperatursensors 9.

Die Übermittlung kann in unterschiedlicher Weise erfolgen.

Soll beispielsweise bei einem Differenzwert gleich Null, d.h. bei gleichen Spannungswerten zwischen Mittenanzapfung 8 und Plus- bzw. Minus-Anschluß 4, 5, ein entsprechendes Signal übermittelt werden, so wird bei Vorliegen eines solchen Differenzwertsignals durch den Oszillator 15 die Schalt- und/oder Belastungseinheit 17 mittels der Impulse 16 so gesteuert, daß im gleichen Takt die Fühlerleitung 10 belastet oder hochohmig geschaltet wird. Diese simulierten Temperatursprünge können beispielsweise von der in der Ladeeinrichtung 7 enthaltenen Steuereinrichtung erfaßt und ausgewertet werden. Dadurch, daß die Taktung der Fühlerleitung beispielsweise mit Frequenzen im Bereich von 0,5 bis 10 s⁻¹ erfolgt, kann dieses Signal von dem durch den Temperatursensor ermittelten Temperatursignal in einfacher Weise getrennt werden. Das eigentliche Temperatursignal unterliegt keinen solchen kurzzeitigen Temperatursprüngen, da die Temperaturmessung innerhalb des Batterieschranks 14 relativ träge ist.

Es ist ebenso möglich, eine Taktung der Fühlerleitung dann durchzuführen, wenn die ermittelte Spannungsdifferenz größer als ein vorbestimmter Wert ist. Dies entspricht einem Fehler im Batteriesatz, wie beispielsweise dem Ausfall einer oder mehrerer Einzelbatterien.

Ebenso kann eine Taktung, insbesondere mit anderer Frequenz als hinsichtlich der Überwachung des Batteriesatzes 2 erfolgen, um beispielsweise eine nicht angeschlossene Mittenanzapfung mitzuteilen.

Bevorzugt wird erfindungsgemäß die Fühlerleitung bei einer Unsymmetrie des Batteriesatzes, d.h. bei einer Spannungsdifferenz, und beispielsweise bei nicht angeschlossener Mittenanzapfung getaktet.

Die entsprechende Übermittlung der Information kann auch dadurch erfolgen, daß durch die Schalt- und/oder Belastungseinheit 17 ein getaktetes Kurzschließen und Öffnen der Fühlerleitung erfolgt. Dies kann bei einer Unsymmetrie oder auch umgekehrt bei einer Symmetrie des Batteriesatzes erfolgen. Bei dem getakteten Kurzschließen und Öffnen der Fühlerleitung ist allerdings zu beachten, daß in diesem Fall nicht stetig eine Temperaturüberwachung innerhalb des Batterieschrankes 14 und ebenfalls eine Temperaturführung der Ladeeinrichtung 7 möglich ist.

## Patentansprüche

1. Verfahren zur Überwachung wenigstens eines zur Notversorgung von elektrischen und/oder elektronischen Verbrauchern, insbesondere von Zentralbatterie-Notlichtsystemen, zuschaltbaren Batteriesatzes (2), wobei eine Steuereinrichtung (3) wenigstens eine Gesamtspannung zwischen Puls- und Minus-Anschluss (4, 5) einer Anzahl von in Reihe geschalteten Batterien (6) des Batteriesatzes (2) misst und die Batterie mittels einer Ladeeinrichtung (7) gegebenenfalls wieder auflädt,
**dadurch gekennzeichnet, dass** neben der Gesamtspannung über zumindest eine Anzapfung (8, 11) des Batteriesatzes (2) Spannungen zwischen Anzapfung und jeweils Plus- und Minus-Anschluss (4, 5) gemessen werden und dass eine mit der Anzapfung (8, 11) verbundene Vergleicherschaltung (12) einen Differenzwert der Spannungen zwischen Anzapfung und Plus- bzw. Minus- Anschluss ermittelt und zur Übermittlung eines Differenzwertsignals an die Steuer- und/oder Ladeeinrichtung (3, 7) die Vergleicherschaltung (12) eine Taktung einer Fühlerleitung (10) in Abhängigkeit des Differenzwertes auslöst, wobei die Übertragung des Differenzwertsignals bei einem Differenzwert der gemessenen Spannungen größer als einem vorgegebenem Grenzdifferenzwert erfolgt.

2. Verfahren zur Überwachung nach Anspruch 1, **dadurch gekennzeichnet, dass** die Anzapfung (8, 11) des Batteriesatzes (2) mittig erfolgt.

3. Verfahren zur Überwachung nach Anspruch 1 oder 2, **dadurch gekennzeichnet, dass** die Messung der Spannungen und/oder die Ermittlung des Differenzwertes und/oder die Übertragung des Differenzwertsignals kontinuierlich erfolgt.

4. Verfahren zur Überwachung nach wenigstens einem der vorangehenden Ansprüche, **dadurch gekennzeichnet, dass** ein Temperatursensor (9) die Temperatur in der Umgebung des Batteriesatzes (2) misst und ein Temperatursignal an die Steuer- und/oder Ladeeinrichtung (2, 7) über die Fühlerleitung (10) insbesondere zur temperaturgeführten Ladung des Batteriesatzes übermittelt.

5. Verfahren zur Überwachung nach Anspruch 4, **dadurch gekennzeichnet, dass** die Steuer- und/oder Ladeeinrichtung (3, 7) das Differenzwertsignal über die Fühlerleitung (10) empfängt.

6. Verfahren zur Überwachung nach Anspruch 5, **dadurch gekennzeichnet, dass** das Differenzwertsignal durch getaktetes Belasten oder Hochohmigschalten der Fühlerleitung (10) übertragen wird.

7. Verfahren zur Überwachung nach Anspruch 6, **dadurch gekennzeichnet, dass** das Differenzwertsignal durch getaktetes Kurschließen und Öffnen der Fühlerleitung (10) übertragen wird.

8. Verfahren zur Überwachung nach wenigstens einem der vorangehenden Ansprüche, **dadurch gekennzeichnet, dass** die Vergleicherschaltung (12) eine fehlende Anzapfung (8, 11) detektiert und ein entsprechendes Signal an die Steuer- und/oder Ladeeinrichtungen (3, 7) insbesondere über die Fühlerleitung (10) übermittelt.

9. Verfahren zur Überwachung nach wenigstens einem der vorangehenden Ansprüche, **dadurch gekennzeichnet, dass** die Taktung der Fühlerleitung (10) zur Informationsübermittlung mit an einem Taktgeber (15) einstellbarer Taktfrequenz erfolgt.

10. Verfahren zur Überwachung nach wenigstens einem der vorangehenden Ansprüche, **dadurch gekennzeichnet, dass** der Grenzdifferenzwert an der Vergleicherschaltung eingestellt wird.

11. Verfahren zur Überwachung nach wenigstens einem der vorangehenden Ansprüche 5 bis 10, **dadurch gekennzeichnet, dass** zur Taktung der erzeugte Takt dem Meßsignal des Temperatursensors aufmoduliert ist.

12. Überwachungsvorrichtung (1) zur Durchführung des Verfahrens nach einem der vorangehenden Ansprüche mit einem zuschaltbaren, einem Plus- und einem Minus-Anschluss (4, 5) aufweisenden Batteriesatz (2) aus einer Anzahl von in Reihe geschalteten Batterien (6), wobei die Überwachungsvorrichtung (1) wenigstens mit dem Plus- und Minus-Anschluss (4 5) zur Ermittlung der Gesamtspannung verschaltet ist, **dadurch gekennzeichnet, dass** die Überwachungsvorrichtung mit wenigstens einer weiteren Spannungsanzapfung (8, 11) des Batteriesatzes (2) verschaltet ist und eine Vergleicherschaltung (12) zur Ermittlung von Spannungswerten zwischen Spannungsanzapfung (8, 11) und Plus- und Minus-Anschlüssen (4, 5) sowie zur Auswertung einer Spannungsdifferenz zwischen diesen Spannungswerten aufweist, wobei die Vergleicherschaltung (12) eine Auswerteeinheit (13) aufweist, welche mit einem Taktgeber (15) zur Ausgabe von Impulsen zumindest in Abhängigkeit von einem Spannungsdifferenzwert über eine Fühlerleitung verschaltet ist.

13. Überwachungsvorrichtung nach Anspruch 12, **dadurch gekennzeichnet, dass** die Spannungsanzapfung (8, 11) wenigstens eine Mittenanzapfung (11) ist.

14. Überwachungsvorrichtung nach Anspruch 12 oder 13, **dadurch gekennzeichnet, dass** eine Ladeeinrichtung (7) und die Überwachungsvorrichtung (1) parallel mit den Plus- und Minus-Anschlüssen (4, 5) verschaltet sind.

15. Überwachungsvorrichtung nach wenigstens einem der Ansprüche 12 bis 14, **dadurch gekennzeichnet, dass** der Batteriesatz (2) zusammen mit zumindest der Überwachungsvorrichtung (1) in einem Batterieschrank (14) angeordnet ist.

16. Überwachungsvorrichtung nach wenigstens einem der vorangehenden Ansprüche 12 bis 15, **dadurch gekennzeichnet, dass** ein Temperatursensor (9) dem Batteriesatz (2) zur Messung der Umgebungstemperatur zugeordnet und der Temperatursensor (9) mit der Ladeeinrichtung (7) und/oder einer die Ladeeinrichtung steuernden Steuereinrichtung (3) über die Fühlerleitung (10) verbunden ist.

17. Überwachungsvorrichtung nach wenigstens einem der Ansprüche 12 bis 16, **dadurch gekennzeichnet, dass** die die Ladung des Batteriesatzes (2) über die Ladeeinrichtung (7) steuernde Steuereinrichtung (3) Teil der Ladeeinrichtung (7) ist.

18. Überwachungsvorrichtung nach wenigstens einem der Ansprüche 12 bis 17, **dadurch gekennzeichnet dass** die Überwachungsvorrichtung (1) mit dem Batteriesatz (2) zur Spannungsversorgung verbunden ist.

19. Überwachungsvorrichtung nach wenigstens einem der Ansprüche 12 bis 18, **dadurch gekennzeichnet, dass** die Vergleicherschaltung (12) mit dem Plus- und Minus-Anschluss (4, 5) und der zumindest einen weiteren Anzapfung (8, 11) des Batteriesatzes (2) zur Bestimmung der Spannungsdifferenz verbunden ist.

20. Überwachungsvorrichtung nach einem der Ansprüche 12 bis 19, **dadurch gekennzeichnet, dass** der Taktgeber (15) ein insbesondere in der Taktfrequenz einstellbarer Oszillator ist.

21. Überwachungsvorrichtung nach einem der Ansprüche 12 bis 20, **dadurch gekennzeichnet, dass** der Taktgeber (15) zur Übertragung von Spannungsimpulsen (16) mit der Steuer- und/oder Ladeeinrichtung (3, 7) über die Fühlerleitung (10) verbunden ist.

22. Überwachungsvorrichtung nach wenigstens einem der vorangehenden Ansprüche 12 bis 21, **dadurch gekennzeichnet, dass** zwischen Taktgeber (15) und Fühlerleitung (10) eine Schalt- und/oder Belastungseinheit (17) als Teil der Überwachungsvorrichtung (1) zum Kurzschließen oder Öffnen bzw. zur Belastung oder zum Hochohmigschalten der Fühlerleitung (10) verschaltet ist.

23. Überwachungsvorrichtung nach wenigstens einem der vorangehenden Ansprüche 16 bis 22, **dadurch gekennzeichnet, dass** die Überwachungsvorrichtung (1) als Nachrüstsatz zwischen Temperatursensor (9) und Fühlerleitung (10) innerhalb des Batterieschrankes (14) sowie mit Verbindungsleitungen zum Plus- und Minus-Anschluss (4, 5) einsetzbar ist.

## Claims

1. Method for monitoring at least one battery set (2) which can be switched on for the emergency supply of electric and/or electronic consumers, in particular of central battery emergency lighting systems, wherein a control device (3) measures at least one total voltage between plus and minus terminals (4, 5) of a number of batteries, (6) switched in series, of the battery set (2) and if necessary recharges the battery by means of a charging device (7), **characterised in that** as well as the total voltage over at least one tapping point (8, 11) of the battery set (2) voltages are measured between the tapping point and the plus and minus terminals (4, 5) in each case and a comparator circuit (12) connected to the tapping point (8, 11) determines a differential value of the voltages between the tapping point and the plus or minus terminal and for conveying a differential value signal to the control and/or charging device (3, 7) the comparator circuit (12) triggers clocking of a sensor line (10) as a function of the differential value, wherein transmission of the differential value signal takes place if a differential value of the measured voltages is greater than a preset limit differential value.

2. Method for monitoring according to claim 1, **characterised in that** tapping (8, 11) of the battery set (2) takes place: in the centre.

3. Method for monitoring according to claim 1 or 2, **characterised in that** measuring the voltages and/or determining the differential value and/or transmission of the differential value signal takes place continuously.

4. Method for monitoring according to at least one of the preceding claims, **characterised in that** a temperature sensor (9) measures the temperature in the environment of the battery set (2) and conveys a temperature signal to the control and/or charging device (2, 7) via the sensor line (10), in particular for temperature-controlled charging of the battery set.

5. Method for monitoring according to claim 4, **characterised in that** the control and/or charging device (3, 7) receives the differential value signal via the sensor line (10).

6. Method for monitoring according to claim 5, **characterised in that** the differential value signal is transmitted by clocked loading or high-ohm switching of the sensor line (10).

7. Method for monitoring according to claim 6, **characterised in that** the differential value signal is transmitted by clocked short-circuiting and opening of the sensor line (10).

8. Method for monitoring according to at least one of the preceding claims, **characterised in that** the comparator circuit (12) detects a defective tapping point (8, 11) and conveys an appropriate signal to the control and/or charging devices (3, 7), in particular via the sensor line (10).

9. Method for monitoring according to at least one of the preceding claims, **characterised in that** the clocking of the sensor line (10) for conveying information takes place at a clock frequency which can be set on a clock generator (15).

10. Method for monitoring according to at least one of the preceding claims, **characterised in that** the limit differential value is set on the comparator circuit.

11. Method for monitoring according to at least one of preceding claims 5 to 10, **characterised in that** for clocking the clock generated is modulated up to the measuring signal of the temperature sensor.

12. Monitoring device (1) for carrying out the method according to one of the preceding claims with a battery set (2) which can be switched on, has a plus and a minus terminal (4, 5) and consists of a number of batteries (6) switched in series, wherein the monitoring device (1) is switched at least to the plus and minus terminal (4, 5) for determining the total voltage, **characterised in that** the monitoring device is switched to at least one further voltage tapping point (8, 11) of the battery set (2) and has a comparator circuit (12) for determining voltage values between the voltage tapping point (8, 11) and the plus and minus terminals (4, 5) and for evaluating a difference in voltage between these voltage values, wherein the comparator circuit (12) has an evaluation unit (13) which is switched via a sensor line to a clock generator (15) for issuing pulses at least as a function of a voltage differential value.

13. Monitoring device according to claim 12, **characterised in that** the voltage tapping point (8, 11) is at least a central tapping point (11).

14. Monitoring device according to claim 12 or 13, **characterised in that** a charging device (7) and the monitoring device (1) are switched parallel to the plus and minus terminals (4, 5).

15. Monitoring device according to at least one of claims 12 to 14, **characterised in that** the battery set (2) is arranged together with at least the monitoring device (1) in a battery cupboard (14).

16. Monitoring device according to at least one of preceding claims 12 to 15, **characterised in that** a temperature sensor (9) is allocated to the battery set (2) for measuring the ambient temperature and the temperature sensor (9) is connected to the charging device (7) and/or a control device (3) controlling the charging device via the sensor line (10).

17. Monitoring device according to at least one of claims 12 to 16, **characterised in that** the charging of the battery set (2) via the control device (3) controlling the charging device (7) is part of the charging device (7).

18. Monitoring device according to at least one of claims 12 to 17, **characterised in that** the monitoring device (1) is connected to the battery set (2) for voltage supply.

19. Monitoring device according to at least one of claims 12 to 18, **characterised in that** the comparator circuit (12) is connected to the plus and minus terminal (4, 5) and to the at least one further tapping point (8, 11) of the battery set (2) for determining the voltage difference.

20. Monitoring device according to one of claims 12 to 19, **characterised in that** the clock generator (15) is an oscillator which is settable in particular in clock frequency.

21. Monitoring device according to one of claims 12 to 20, **characterised in that** the clock generator (15) is connected to the control and/or charging device (3, 7) via the sensor line (10) for transmitting voltage pulses (16).

22. Monitoring device according to at least one of preceding claims 12 to 21, **characterised in that** a switching and/or loading unit (17) is switched between the clock generator (15) and the sensor line (10) as part of the monitoring device (1) for short-circuiting or opening or for loading or for high-ohm switching of the sensor line (10).

23. Monitoring device according to at least one of preceding claims 16 to 22, **characterised in that** the monitoring device (1) can be used as a retrofit kit between the temperature sensor (9) and the sensor line (10) inside the battery cupboard (14) and also with connecting lines to the plus and minus terminals (4, 5).

## Revendications

1. Procédé pour la surveillance d'au moins un ensemble de batteries (2), qui peut être branché pour l'alimentation de secours d'appareils d'utilisation électriques et/ou électroniques, notamment de systèmes d'éclairage de secours de batterie centrale, selon lequel un dispositif de commande (3) mesure au moins une tension complète entre la borne positive et la borne négative (4, 5) d'un nombre de batteries (6), branchées en série, de l'ensemble de batteries (2) et recharge éventuellement la batterie à l'aide d'un dispositif de charge (7), **caractérisé en ce qu'**en dehors de la tension complète, on mesure à l'aide d'au moins une prise de prélèvement (en 8, 11) sur l'ensemble de batteries (2), des tensions entre la prise et la borne positive et la borne négative (4, 5) et qu'un circuit comparateur (12) relié à la prise de prélèvement (8, 11) détermine une valeur de différence des tensions entre la prise et la borne positive et la borne négative et, pour la transmission d'un signal de valeur de différence au dispositif de commande et/ou de charge (3, 7), le circuit comparateur (12) déclenche un cadencement d'une ligne de capteur (10) en fonction de la valeur de différence, la transmission du signal de valeur de différence s'effectuant dans le cas où une valeur de différence des tensions mesurées est supérieure à une valeur de différence limite prédéterminée.

2. Procédé de surveillance selon la revendication 1, **caractérisé en ce que** le prélèvement (en 8, 11) sur l'ensemble de batterie (2) s'effectue de façon centrée.

3. Procédé de surveillance selon la revendication 1 ou 2, **caractérisé en ce que** la mesure des tensions et/ou la détermination de valeur de différence et/ou la transmission du signal de valeur de différence s'effectuent continûment.

4. Procédé de surveillance selon au moins l'une des revendications précédentes, **caractérisé en ce qu'**un capteur de température (9) mesure la température dans l'environnement de l'ensemble de batteries (2) et transmet un signal de température au dispositif de commande et/ou de charge (3, 7) par l'intermédiaire de la ligne de capteur (10), notamment pour exécuter la charge, pilotée par la température, de l'ensemble de batteries.

5. Procédé de surveillance selon la revendication 4, **caractérisé en ce que** le dispositif de commande et/ou de charge (3, 7) reçoit le signal de valeur de différence au moyen de la ligne de capteur (10).

6. Procédé de surveillance selon la revendication 5, **caractérisé en ce que** le signal de valeur de différence est transmis au moyen d'une sollicitation ou d'une commutation cadencée sur une forte valeur ohmique de la ligne de capteur (10).

7. Procédé de surveillance selon la revendication 6, **caractérisé en ce que** le signal de valeur de différence est transmis par un court-circuitage et une ouverture cadencés de la ligne de capteur (10).

8. Procédé de surveillance selon au moins l'une des revendications précédentes, **caractérisé en ce que** le circuit comparateur (12) détecte un prélèvement défectueux (8, 11) et transmet un signal correspondant aux dispositifs de commande et/ou de charge (3, 7) notamment par l'intermédiaire de la ligne de capteur (10).

9. Procédé de surveillance selon au moins l'une des revendications précédentes, **caractérisé en ce que** le cadencement de la ligne de capteur (10) pour la transmission d'informations s'effectue avec une fréquence de cadence réglable dans un générateur de cadence (15).

10. Procédé de surveillance selon au moins l'une des revendications précédentes, **caractérisé en ce que** la valeur de différence limite est réglée dans le circuit comparateur.

11. Procédé de surveillance selon au moins l'une des revendications précédentes 5 à 10, **caractérisé en ce que** pour le cadencement, le signal de mesure du capteur de température est modulé par la cadence produite.

12. Dispositif de surveillance (1) pour la mise en oeuvre du procédé selon l'une des revendications précédentes, comportant un ensemble pouvant être branché (2) de batteries, qui comporte une borne positive et une borne négative (4, 5) et est constitué par un nombre de batteries (6) branchées en série, dans lequel le dispositif de surveillance (1) est connecté au moins à la borne positive et à la borne négative (4, 5) pour la détermination de la tension complète, **caractérisé en ce que** le dispositif de surveillance est connecté à au moins une autre prise (8, 11) de prélèvement de tension de l'ensemble de batteries (2) et comporte un circuit comparateur (12) servant à déterminer des valeurs de tension entre la prise (8, 11) de prélèvement de tension et les bornes positive et négative (4, 5) ainsi que pour l'évaluation d'une différence de tension entre ces valeurs de tension, le circuit comparateur (12) comportant une unité d'évaluation (13), qui est connectée à un générateur de cadence (15) pour la délivrance d'impulsions au moins en fonction d'une valeur de différence de tension au moyen d'une ligne de capteur.

13. Dispositif de surveillance selon la revendication 12, **caractérisé en ce que** la prise (8, 11) de prélèvement de tension est au moins une prise médiane (11).

14. Dispositif de surveillance selon la revendication 12 ou 13, **caractérisé en ce qu'**un dispositif de charge (7) et le dispositif de surveillance (1) sont connectés en parallèle avec les bornes positive et négative (4, 5).

15. Dispositif de surveillance selon au moins l'une des revendications 12 à 14, **caractérisé en ce que** l'ensemble de batteries (2) est disposé, conjointement avec au moins le dispositif de surveillance (1), dans une armoire à batteries (14).

16. Dispositif de surveillance selon au moins l'une des revendications précédentes 12 à 15, **caractérisé en ce qu'**un capteur de température (9) est associé à l'ensemble de batteries (2) pour la mesure de la température ambiante et que le capteur de température (9) est relié au dispositif de charge (7) et/ou à un dispositif de commande (3) commandant le dispositif de charge, par l'intermédiaire d'une ligne de capteur (10).

17. Dispositif de surveillance selon au moins l'une des revendications 12 à 16, **caractérisé en ce que** le dispositif de commande (3), qui commande la charge de l'ensemble de batteries (2) au moyen du dispositif de charge (7), fait partie du dispositif de charge (7).

18. Dispositif de surveillance selon au moins l'une des revendications 12 à 17, **caractérisé en ce que** le dispositif de surveillance (1) est relié à l'ensemble de batteries (2) pour l'alimentation en tension.

19. Dispositif de surveillance selon au moins l'une des revendications 12 à 18, **caractérisé en ce que** le circuit comparateur (12) est relié à la borne positive et à la borne négative (4, 5) et à au moins une autre prise (8, 11) de l'ensemble de batteries (2) pour la détermination de la différence de tension.

20. Dispositif de surveillance selon l'une des revendications 12 à 19, **caractérisé en ce que** le générateur de cadence (15) est un oscillateur dont la fréquence de cadence est notamment réglable.

21. Dispositif de surveillance selon l'une des revendications 12 à 20, **caractérisé en ce que** le générateur de cadence (15) est relié, pour le contrôle d'impulsions de tension (16), au dispositif de commande et/ou de charge (3, 7) par l'intermédiaire de la ligne de capteur (10).

22. Dispositif de surveillance selon au moins l'une des revendications précédentes 12 à 21, **caractérisé en ce qu'**une unité de commutation et/ou de charge (17) est branchée entre le générateur de cadence (15) et la ligne de capteur (10), en tant que partie du dispositif de surveillance (1) pour le court-circuitage ou l'ouverture pour la charge ou la commutation à une forte valeur ohmique de la ligne de capteur (10).

23. Dispositif de surveillance selon au moins l'une des revendications précédentes 12 à 22, **caractérisé en ce que** le dispositif de surveillance (1) peut être utilisé en tant qu'ensemble pouvant être monté ultérieurement entre un capteur de température (9) et une ligne de capteur (10) à l'intérieur de l'armoire à batteries (14) ainsi qu'avec des lignes de liaison avec les bornes positive et négative (4, 5).
